# EUROPEAN PATENT APPLICATION

(11) **EP 4 717 513 A1**
(43) Date of publication of application: **01.04.2026**
(21) Application number: 24843503.4
(22) Date of filing: 17.07.2024
(51) Int. Cl.: B60L 53/80, B60L 53/60, B60L 53/30, G01R 27/02

(54) **BATTERY SWAPPING SYSTEM, BATTERY SWAPPING DEVICE, AND MANAGEMENT METHOD THEREOF**

(30) Priority: 19.07.2023 KR 20230093816
(71) Applicant: LG Energy Solution, Ltd., Seoul 07335 (KR)
(72) Inventor: CHOI, Yean Sik, Daejeon 34122 (KR)
(74) Representative: Plasseraud IP
(86) International application number: PCT/KR2024/010273
(87) International publication number: WO 2025/018788

(57) **Abstract**

A battery swapping system according to an embodiment disclosed herein includes a plurality of battery swapping apparatuses configured to accommodate swappable batteries and an integrated controller configured to manage operations of the plurality of battery swapping apparatuses, measure an insulation resistance related to each of the plurality of battery swapping apparatuses, and manage use of the battery swapping apparatus based on the measured insulation resistance.

## Description

### [Technical Field]

### CROSS-REFERENCE TO RELATED APPLICATION

This application claims priority to and the benefit of Korean Patent Application No. 10-2023-0093816 filed in the Korean Intellectual Property Office on July 19, 2023, the entire content of which is incorporated herein by reference.

### TECHNICAL FIELD

Embodiments disclosed herein relate to a battery swapping system, and a battery swapping apparatus and a management method thereof.

### [Background Art]

A battery swapping system stores and charges a swappable battery for electric mobility and provides the same to users. The battery swapping system includes a power source for charging a battery, a battery swapping apparatus, and an internal circuit for charging/discharging and managing a battery.

Each battery swapping apparatus inside the battery swapping system needs to be kept insulated. When insulation of the battery swapping apparatus is broken and shortcircuited, a serious safety problem may occur.

### [Disclosure]

### [Technical Problem]

Embodiments disclosed herein aim to provide a battery swapping system, and a battery swapping apparatus and a management method thereof in which an insulation state of the battery swapping apparatus may be managed.

Embodiments disclosed herein aim to provide a battery swapping system, and a battery swapping apparatus and a management method thereof in which the battery swapping system may be managed and maintained independently.

Technical problems of the embodiments disclosed herein are not limited to the above-described technical problems, and other unmentioned technical problems would be clearly understood by one of ordinary skill in the art from the following description.

### [Technical Solution]

A battery swapping system according to an embodiment disclosed herein includes a plurality of battery swapping apparatuses configured to accommodate swappable batteries and an integrated controller configured to manage operations of the plurality of battery swapping apparatuses, measure an insulation resistance related to each of the plurality of battery swapping apparatuses, and manage use of the battery swapping apparatus based on the measured insulation resistance.

According to an embodiment, the integrated controller may be further configured to determine whether there is a battery swapping apparatus not accommodating a battery among the plurality of battery swapping apparatuses upon receiving a battery swapping request from a user, and manage use of the battery swapping apparatus not accommodating the battery by measuring an insulation resistance of the battery swapping apparatus not accommodating the battery.

According to an embodiment, the integrated controller may be further configured to determine whether maintenance of each battery swapping apparatus is required, by measuring the insulation resistance of each of the plurality of battery swapping apparatuses at predetermined first time intervals.

According to an embodiment, the integrated controller may be further configured to determine whether there is a battery swapping apparatus in use among the plurality of battery swapping apparatuses, stop use of the battery swapping apparatus in use, and measure the insulation resistance of each of the plurality of battery swapping apparatuses.

According to an embodiment, each of the plurality of battery swapping apparatuses may include a connecting portion to which a battery is connected, a measuring unit configured to measure an insulation resistance of at least any one of a first line and a second line connecting a power source for charging the battery to the connecting portion, and a controller configured to control the measuring unit and determine an insulation state of at least any one of the first line and the second line, based on the measured insulation resistance.

According to an embodiment, the measuring unit may include a first insulation resistance measuring unit configured to measure a first insulation resistance that is an insulation resistance of the first line and a second insulation resistance measuring unit configured to measure a second insulation resistance that is an insulation resistance of the second line.

According to an embodiment, the controller may be further configured to control each of the first insulation resistance measuring unit and the second insulation resistance measuring unit to measure at least any one of the first insulation resistance and the second insulation resistance, determine an insulation state of the first line based on the measured first insulation resistance, and determine an insulation state of the second line based on the measured second insulation resistance.

According to an embodiment, the first insulation resistance measuring unit may include a first reference resistor connected between the first line and a ground terminal, a first switch connected to the first reference resistor, and a second switch connected between the second line and the ground terminal, and the second insulation resistance measuring unit may include a second reference resistor connected in parallel to the second switch and connected between the second line and the ground terminal, a third switch connected to the second reference resistor, and a fourth switch connected in parallel to the first reference resistor and connected between the first line and the ground terminal.

According to an embodiment, the controller may be further configured to measure the first insulation resistance by controlling operations of the first switch, the second switch, the third switch, and the fourth switch such that current flows through the first insulation resistance and current does not flow through the second insulation resistance, and measure the second insulation resistance by controlling the operations of the first switch, the second switch, the third switch, and the fourth switch such that current does not flow through the first insulation resistance and current flows through the second insulation resistance.

According to an embodiment, the controller may be further configured to determine that the first line is in an insulation breakdown state when the measured first insulation resistance is less than the first reference resistance and determine that the second line is in the insulation breakdown state when the measured second insulation resistance is less than the second reference resistance.

According to an embodiment, each of the plurality of battery swapping apparatuses may further include a powr switch configured to switch electrical connection between the power source and the connecting portion.

According to an embodiment, the controller may be further configured to open the power switch before measurement of the insulation resistance of at least any one of the first line and the second line.

According to an embodiment disclosed herein, a management method of a battery swapping apparatus includes measuring an insulation resistance of each of a plurality of battery swapping apparatuses configured to accommodate swappable batteries, and managing use of each of the plurality of battery swapping apparatuses, based on the measured insulation resistance.

According to an embodiment, the measuring of the insulation resistance may inculde receiving a battery swapping request from a user, determining whether there is a battery swapping apparatus not accommodating a battery among the plurality of battery swapping apparatuses, and measuring an insulation resistance of the battery swapping apparatus not accommodating the battery, and the managing of the use of the battery swapping apparatus may include determining an insulation state of the battery swapping apparatus not accommodating the battery, based on the measured insulation resistance and determining, based on the determined insulation state, whether to provide the battery swapping apparatus to the user.

According to an embodiment, the measuring of the insulation resistance may include measuring the insulation resistance of each of the plurality of battery swapping apparatuses at predetermined first time intervals, and the managing of the use of the battery swapping apparatus may include determining an insulation state of each battery swapping apparatus, based on the measured insulation resistance and determining, based on the determined insulation state, whether maintenance of each battery swapping apparatus is required.

According to an embodiment, the management method may further include, before the measuring of the insulation resistance of each of the plurality of battery swapping apparatuses, determining whether there is a battery swapping apparatus in use among the plurality of battery swapping apparatuses and stopping use of the battery swapping apparatus in use.

According to an embodiment, the battery swapping apparatus may include a connecting portion to which a battery is connected, a measuring unit configured to measure an insulation resistance of at least any one of a first line and a second line connecting a power source for charging the battery to the connecting portion, and a controller configured to control the measuring unit and determine an insulation state of at least any one of the first line and the second line, based on the measured insulation resistance.

According to an embodiment, the measuring unit may include a first insulation resistance measuring unit configured to measure a first insulation resistance that is an insulation resistance of the first line and a second insulation resistance measuring unit configured to measure a second insulation resistance that is an insulation resistance of the second line.

According to an embodiment, the battery swapping apparatus may further include a powr switch configured to switch electrical connection between the power source and the connecting portion.

### [Advantageous Effects]

A battery swapping system, and a battery swapping apparatus and a management method thereof according to embodiments disclosed herein may manage an insulation state of the battery swapping apparatus.

A battery swapping system, and a battery swapping apparatus and a management method thereof according to embodiments disclosed herein may maintain the battery swapping system and improve safety by managing an insulation state of the battery swapping apparatus.

### [Description of Drawings]

FIG. 1 shows a battery swapping system according to an embodiment disclosed herein.
FIG. 2 is a block diagram of a battery swapping apparatus according to an embodiment disclosed herein.
FIG. 3 is a block diagram showing in detail a battery swapping apparatus according to an embodiment disclosed herein.
FIG. 4 is a circuit diagram showing a battery swapping apparatus according to an embodiment disclosed herein.
FIG. 5 is a circuit diagram showing a battery swapping apparatus according to another embodiment disclosed herein.
FIG. 6 is an operating flowchart of a battery swapping system according to an embodiment disclosed herein.
FIG. 7 is an operating flowchart of a battery swapping system according to another embodiment disclosed herein.
FIG. 8 is a block diagram showing a hardware configuration of a computing system for implementing a battery swapping apparatus according to an embodiment disclosed herein.

### [Mode for Invention]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

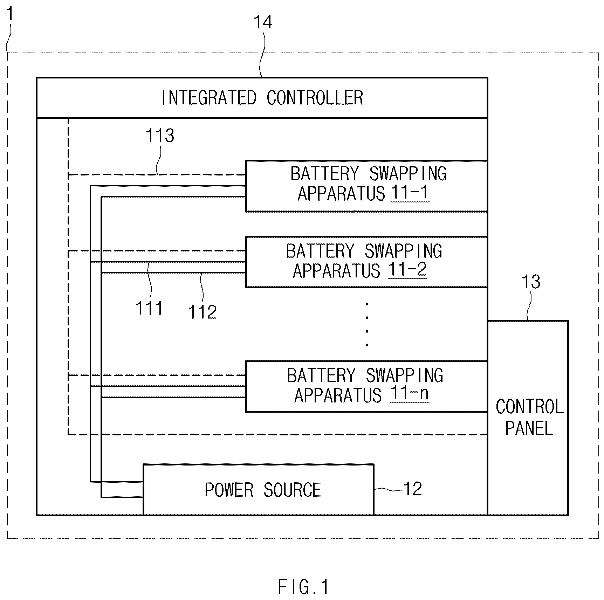

FIG. 1 shows a battery swapping system according to an embodiment disclosed herein.

Referring to FIG. 1, a battery swapping system 1 may include a plurality of battery swapping apparatuses 11-1, 11-2, ..., 11-n, a power source 12, a control panel 13, an integrated controller 14, a power line 111, a ground line 112, and a communication line 113.

The plurality of battery swapping apparatuses 11-1, 11-2, ..., 11-n may respectively accommodate batteries. According to an embodiment, the batteries may include a swappable battery. For example, the swappable battery may be, but not limited to, a battery used for a two-wheeled electric vehicle. The swappable battery may be a battery swappable in the battery swapping system.

The power source 12 may supply power to other components of the battery swapping system 1 (e.g., the plurality of battery swapping apparatuses 11-1, 11-2, ..., 11-n, the control panel 13, the integrated controller 14, etc.). The power source 12 may simultaneously or individually supply power to charge the batteries respectively accomodated in the the plurality of battery swapping apparatuses 11-1, 11-2, ..., 11-n.

According to an embodiment, the power source 12 may supply power to each of the plurality of battery swapping apparatuses 11-1, 11-2, ..., 11-n. According to an embodiment, the power source 12 may receive power from a power network, a power line, a power storage, a power plant, or a substation outside the battery swapping system 1. The power source 12 may convert alternating current power into direct current power. Thus, power transmitted from the power source 12 to each of the plurality of battery swapping apparatuses 11-1, 11-2, ..., 11-n may be direct current power.

The control panel 13 may be provided to communication between the battery swapping system 1 and the user. According to an embodiment, the control panel 13 may be an input/output device that receives a request from the user and outputs information. According to an embodiment, the control panel 13 may be a device capable of both input and output (e.g., a touch screen display). According to an embodiment, the control panel 13 may include an input device (e.g., a keyboard, a card reader, a scanner, a camera, etc.) or an output device (e.g., a display, a speaker, a video card, an audio card, a printer, or other external devices).

The integrated controller 14 may control the plurality of battery swapping apparatuses 11-1, 11-2, ..., 11-n, the power source 12, and the control panel 13. The integrated controller 14 may control an operation of each of the plurality of battery swapping apparatuses 11-1, 11-2, ..., 11-n to manage the use of each of the plurality of battery swapping apparatuses 11-1, 11-2, ..., 11-n.

According to an embodiment, the integrated controller 14 may manage a battery charging operation of each of the plurality of battery swapping apparatuses 11-1, 11-2, ..., 11-n. According to an embodiment, the integrated controller 14 may control each of the plurality of battery swapping apparatuses 11-1, 11-2, ..., 11-n to start battery charging or stop charging.

According to an embodiment, the integrated controller 14 may manage an insulation state of each of the plurality of battery swapping apparatuses 11-1, 11-2, ..., 11-n. To manage the insulation state, the integrated controller 14 may measure an insulation resistance of each of the plurality of battery swapping apparatuses 11-1, 11-2, ..., 11-n. The integrated controller 14 may determine the insulation state of each of the plurality of battery swapping apparatuses 11-1, 11-2, ..., 11-n, based on the measured insulation resistance. The integrated controller 14 may determine that the insulation state is a normal insulation state or an insulation breakdown state.

According to an embodiment, the integrated controller 14 may manage the use of each of the plurality of battery swapping apparatuses 11-1, 11-2, ..., 11-n, according to the determined insulation state of each of the plurality of swapping apparatuses 11-1, 11-2, ..., 11-n. The integrated controller 14 may determine whether each of the plurality of battery swapping apparatuses 11-1, 11-2, ..., 11-n requires maintenance, according to the insulation state.

The integrated controller 14 may control an overall operation of each of the plurality of battery swapping apparatuses 11-1, 11-2, ..., 11-n in addition to the foregoing disclosure. For example, the integrated controller 14 may open or close a door of each of the plurality of battery swapping apparatuses 11-1, 11-2, ..., 11-n.

The integrated controller 14 may also wiredly or wirelessly communicate with a server (not shown) or other control modules located outside the battery swapping system 1.

According to an embodiment, an operation of the integrated controller 14 may be described as below. When a battery insertion request from the user is input to the control panel 13, the integrated controller 14 may determine whether there is a battery swapping apparatus that does not accommodate a battery among the plurality of battery swapping apparatuses 11-1, 11-2, ..., 11-n. When battery swapping apparatuses (e.g., 11-1, 11-2, and 11-3) not accommodating a battery are determined, the integrated controller 14 may determine insulation states of the battery swapping apparatuses 11-1, 11-2, and 11-3. The integrated controller 14 may select one or more of the battery swapping apparatuses (e.g., 11-1 and 11-2) determined as normal insulation states among the battery swapping apparatuses 11-1, 11-2, and 11-3 not accommodating a battery. For example, when the integrated controller 14 selects the battery swapping apparatus 11-1, the integrated controller 14 may open a door of the battery swapping apparatus 11-1. After the battery is accommodated in a slot of the open battery swapping apparatus 11-1, the integrated controller 14 may close the door of the battery swapping apparatus 11-1 and charge the accommodated battery.

As described above, as the integrated controller 14 controls the operation of each of the plurality of battery swapping apparatuses 11-1, 11-2, ..., 11-n and manages the use of each of the plurality of battery swapping apparatuses 11-1, 11-2, ..., 11-n by measuring an insulation resistance, the battery swapping system 1 may independently evaluate the safety of each of the plurality of battery swapping apparatuses 11-1, 11-2, ..., 11-n. The battery swapping system 1 may manage each of the plurality of battery swapping apparatuses 11-1, 11-2, ..., 11-n, thereby maintaining the battery swapping system 1 and guranteeing user's safety.

According to an embodiment, the power line 111 and the ground line 112 may be configured to transmit power of the power source 12 to components in the battery swapping system 1, which consume power. For example, the power of the power source 12 may be transmitted to the plurality of battery swapping apparatuses 11-1, 11-2, ..., 11-n through the power line 111. The ground line 112 may be a reference line that generates a potential difference from the power line 111.

According to an embodiment, the power line 111 may have a voltage different from the ground line 112. For example, the voltage of the power line 111 may be higher than a voltage of the ground line 112. The power line 111 and the ground line 112 in the battery swapping system 1 may be in a floated state without being grounded. Thus, each of the voltages of the power line 111 and the ground line 112 may be different from a ground voltage of the power source of the battery swapping system 1 (a chassis ground voltage of the battery swapping system 1).

The communication line 113 may be configured to allow other components of the battery swapping system 1 to communicate. According to an embodiment, the plurality of swapping apparatuses 11-1, 11-2, ..., 11-n and the control panel 13 may communicate with the integrated controller 14 through the communication line 113.

According to an embodiment, various types of control commands may be transmitted through the communication line 113. The control commands that may be transmitted through the communication line 113 may include a user's request, an electrical signal between internal components of the battery swapping system 1, and so forth.

Although the communication line 113 is shown as an example of a wired communication line according to an embodiment of FIG. 1, the communication line 113 may be configured wirelessly according to another embodiment.

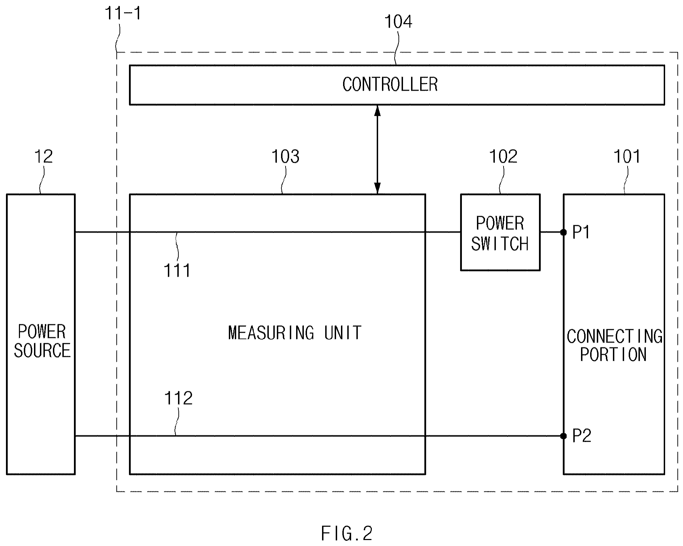

Hereinbelow, referring to FIGS. 2 to 3, the battery swapping apparatus 11-1 will be described. For convenience of a description, among the plurality of battery swapping apparatuses 11-1, 11-2, ..., 11-n, the battery swapping apparatus 11-1 will be described as an example, but the description may be substantially identically applied to the other battery swapping apparatuses 11-2, ..., 11-n.

FIG. 2 is a block diagram of a battery swapping apparatus according to an embodiment disclosed herein.

Referring to FIG. 2, the battery swapping apparatus 11-1 may include a connecting portion 101, a power switch 102, a measuring unit 103, and a controller 104.

The connecting portion 101 may provide electrical connection between a battery accommodated in the battery swapping apparatus 11-1 and the power line 111 and/or the ground line 112. According to an embodiment, the connecting portion 101 may include one or more connecting terminals that contact an electrode or a lead of the battery. For example, the connecting terminal may include a first connecting terminal P1 and a second connecting terminal P2. According to an embodiment, the first connecting terminal P1 may be connected to the power line 111, and the second connecting terminal P2 may be connected to the ground line 112.

According to an embodiment, the connecting portion 101 may sense whether a battery is accommodated in the battery swapping apparatus 11-1. According to an embodiment, the connecting portion 101 may include a sensor (not shown) that senses whether the battery is connected to the connecting portion. According to an embodiment, the connecting portion 101 may be configured in the form of a slot tha accommodates the battery, without being limited thereto.

The power switch 102 may switch electrical connection between the power source 12 of the battery swapping system 1 and the battery accommodated in the battery swapping apparatus 11-1. According to an embodiment, the power switch 102 may switch power transmission between the connecting portion 101 and the power source 12. According to an embodiment, the power switch 102 may be disposed on the power line 111, without being limited thereto.

The measuring unit 103 may measure an insulation resistance of the battery swapping apparatus 11-1. According to an embodiment, the measuring unit 103 may measure an insulation resistance of a line of the battery swapping system 1 in which the line connects the connecting portion 101 to the power source 12. According to an embodiment, the measuring unit 103 may measure an insulation resistance of at least any one of the power line 111 and the ground line 112.

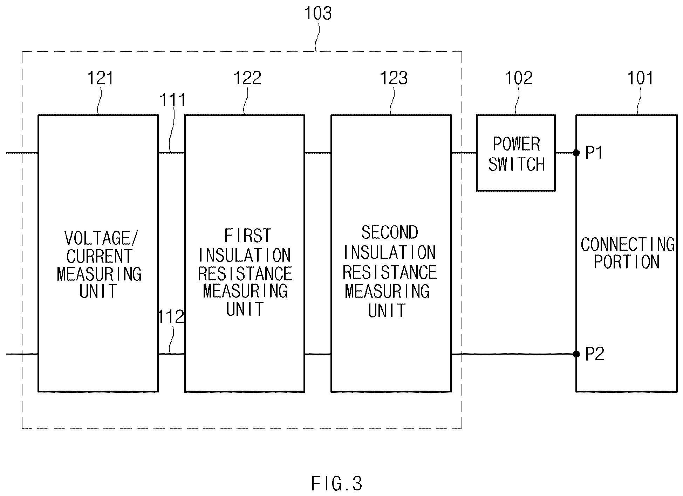

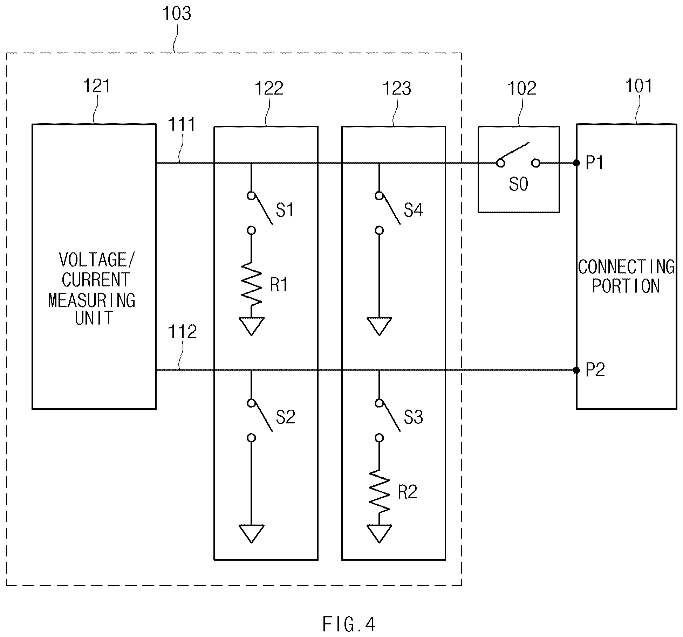

According to an embodiment, the measuring unit 103 may include at least some of the power line 111 and the ground line 112. The measuring unit 103 will be described below with reference to FIGS. 3 and 4.

The controller 104 may control an operation of the battery swapping apparatus 11-1. According to an embodiment, the controller 104 may control operations of the connecting portion 101, the power switch 102, and the measuring unit 103.

According to an embodiment, the controller 104 may control the battery swapping apparatus 11-1 based on information obtained from the connecting portion 101. According to an embodiment, the controller 104 may control the measuring unit 103 to measure the insulation resistance of the battery swapping apparatus 11-1. The controller 104 may control the power switch 102 and the measuring unit 103 to measure an insulation resistance of at least one of the power line 111 and the ground line 112. According to an embodiment, the controller 104 may control the power switch 102 to be opened before measurement of the insulation resistance. The measurement of the insulation resistance will be described below with reference to FIGS. 3 and 4.

The controller 104 may determine the insulation state of the battery swapping apparatus 11-1, based on the insulation resistance measured by the measuring unit 103. For example, the controller 104 may determine the insulation state of the power line 111 and/or the ground line 112 based on the measured insulation resistance of the power line 111 and/or the ground line 112. In this way, the controller 104 may manage the state of the battery swapping apparatus 11-1.

According to an embodiment, the controller 104 may request maintenance of the battery swapping apparatus 11-1 to a higher-level controller (e.g., the integrated controller 14) when determining that the power line 111 is in an insulation breakdown state. According to an embodiment, the controller 104 may request maintenance of the battery swapping apparatus 11-1 to a higher-level controller (e.g., the integrated controller 14) when determining that any one of the power line 111 is in an insulation breakdown state. Thus, the controller 104 may measure the insulation resistance of the power line 111 or the ground line 112 to manage the battery swapping apparatus 11-1.

The controller 104 may transmit the determined insulation state of the battery swapping apparatus 11-1 to the integrated controller 14. Based on the insulation state of the battery swapping apparatus 11-1 received from the controller 104, the integrated controller 14 may determine whether the battery swapping apparatus 11-1 may be used for battery swapping. The integrated controller 14 may determine whether maintence of the battery swapping apparatus 11-1 is required according to the insulation state of the battery swapping apparatus 11-1.

Through the controller 104 and the integrated controller 14, the battery swapping system 1 may independently evaluate safety of the battery swapping apparatus 11-1. The battery swapping system 1 may also guarantee safety of the user of the battery swapping apparatus 11-1 and efficiently maintain the battery swapping apparatus 11-1.

The controller 104 may be wirelessly or wiredly connected to components in the battery swapping system 1. The controller 104 may be connected to the integrated controller 14, the connecting portion 101, the power switch 102, and the measuring unit 103 through the communication line 113.

FIG. 3 is a block diagram showing in detail a battery swapping apparatus according to an embodiment disclosed herein.

Referring to FIG. 3, a voltage/current measuring unit 121 may apply voltage or current to the battery swapping apparatus 11-1 to measure the insulation resistance of the battery swapping apparatus 11-1. The voltage/current measuring unit 121 may also measure a current flowing through the battery swapping apparatus 11-1 or a voltage of the battery swapping apparatus 11-1, based on the voltage or current applied to the battery swapping apparatus 11-1. Thus, the voltage/current measuring unit 121 may calculate the insulation resistance of the battery swapping apparatus 11-1, based on the measured voltage or current.

According to an embodiment, the voltage/current measuring unit 121 may measure an alternating current flowing through the battery swapping apparatus 11-1 or an alternating voltage of the battery swapping apparatus 11-1, based on an alternating voltage or alternating current applied to the battery swapping apparatus 11-1. The voltage/current measuring unit 121 may calculate an impedance of the battery swapping apparatus 11-1, based on the measured alternating voltage or alternating current.

According to an embodiment, the voltage/current measuring unit 121 may include an electrochemical impedance spectroscopy (EIS) measurement system. The EIS measurement system may calculate the impedance by generating a profile expressing a resistance of the battery swapping apparatus 11-1 at each frequency with a correspondence between a real part and an imaginary part. For example, the voltage/current measuring unit 121 may include an EIS board. The EIS board may include an internal circuit that calculates the impedance based on the measured alternating voltage or alternating current.

The voltage/current measuring unit 121 may measure a first insulation resistance through the first insulation resistance measuring unit 122. According to an embodiment, the first insulation resistance may be an insulation resistance of a line connecting the power source 12 to the connecting portion 101. The first insulation resistance may be an insulation resistance of the power line 111. Thus, the first insulation resistance may be calculated based on a voltage or a current of the first insulation resistance measuring unit 122, measured by the voltage/current measuring unit 121.

The voltage/current measuring unit 121 may measure a second insulation resistance through the second insulation resistance measuring unit 123. According to an embodiment, the second insulation resistance may be an insulation resistance of another line connecting the power source 12 to the connecting portion 101. The second insulation resistance may be an insulation resistance of the ground line 112. Thus, the second insulation resistance may be calculated based on a voltage or a current of the second insulation resistance measuring unit 123, measured by the voltage/current measuring unit 121.

FIG. 4 is a circuit diagram showing a battery swapping apparatus according to an embodiment disclosed herein.

Referring to FIG. 4, the power switch 102 may include a switch S0 for switching electrical connection between the power source 12 and the battery accommodated in the battery swapping apparatus 11-1. According to an embodiment, the switch S0 may be disposed on the power line 111. For example, the switch S0 may be, but not limited to, at least one of a relay or an FET. According to an embodiment, the switch S0 may be controlled by the controller 104.

The controller 104 may open the power switch 102 before measurement of the insulation resistance of the battery swapping apparatus 11-1. As the switch S0 is opened by the controller 104, the electrical connection between the power source 12 and the connecting portion 101 may be blocked. That is, as the power switch S0 is opened before measurement of the insulation resistance, power transmitted from the power source 12 to the connecting portion 101 may be blocked. Thus, the battery may be electrically separated from the measuring unit 103 before measurement of the insulation resistance. In this way, the insulation resistance of the battery swapping apparatus 11-1 may be accurately measured. In addition, by opening the power switch S0 even when the battery is connected to the connecting portion 101, the electrical connection may be blocked, such that the insulation resistance may be measured merely by controlling the power switch 102 without physically removing the battery. In this way, the safety of the battery swapping apparatus 11-1 may be evaluated, and the battery swapping apparatus 11-1 may be efficiently maintained.

The power line 111 may be disposed between the voltage/current measuring unit 121 and the first connecting terminal P1 of the connecting portion 101. According to an embodiment, the power line 111 may be electrically connected to a first pole of the battery.

The ground line 112 may be disposed between the voltage/current measuring unit 121 and the second connecting terminal P2 of the connecting portion 101. According to an embodiment, the ground line 112 may be electrically connected to a second pole of the battery.

According to an embodiment, the power line 111 and the ground line 112 may have different voltages. According to an embodiment, each of the power line 111 and the ground line 112 may have a voltage different from a ground voltage of the power source of the battery swapping system 1 (a chassis ground voltage of the battery swapping system 1).

The voltage/current measuring unit 121 may measure the insulation resistance of the battery swapping apparatus 11-1.

According to an embodiment, the first insulation resistance measuring unit 122 may include a first reference resistor R1 connected between the power line 111 and a ground terminal, a first switch S1 connected to the first reference resistor R1, and a second switch S2 connected between the ground line 112 and the ground terminal. The ground terminal may be the same as the ground voltage of the power source of the battery swapping system 1 (the chassis ground voltage of the battery swapping system 1).

The first switch S1 and the second switch S2 may switch current flowing through the first insulation resistance measuring unit 122. For example, the first switch S1 and the second switch S2 may be at least one of a relay or an FET. The first switch S1 and the second switch S2 may be controlled by a controller (104, see FIG. 2).

The first reference resistor R1 may be an insulation resistance that is a criterion for determining the insulation state of the power line 111 of the battery swapping apparatus 11-1. According to an embodiment, when the power line 111 is in a normal insulation state, a first insulation resistance value measured by the first insulation resistance measuring unit 122 may be the same as a value of the first reference resistor R1 or within an equivalent range thereto. The value of the first reference resistor R1 may be, but not limited to, between n*10³ Ω (kΩ) and n*10⁶ Ω (MΩ), in which n is a value between 1 and 1000.

According to an embodiment, when the insulation of the power line 111 is broken down, the insulation resistance value of the power line 111 may be measured as if a resistor Rx (not shown) having a value less than the first reference resistor R1 is connected in prallel to the first reference resistor R1. In this case, the value of the resistor Rx may be less than the value of the first reference resistor R1. The value of the resistor Rx may be, but not limited to, between n Ω and n*10³ Ω (kΩ), in which n is a value between 1 and 1000. According to an embodiment, when the power line 111 is in an insulation breakdown state, the measured first insulation resistance value may be less than a half of the value of the first reference resistor R1.

The voltage/current measuring unit 121 may measure the second insulation resistance through the second insulation resistance measuring unit 123. According to an embodiment, the second insulation resistance measuring unit 123 may include a second reference resistor R2 connected between the ground line 112 and the ground terminal, a third switch S3 connected to the second reference resistor R2, and a fourth switch S4 connected between the power line 111 and the ground terminal. The ground terminal may be the same as the ground voltage of the power source of the battery swapping system 1 (the chassis ground voltage of the battery swapping system 1).

The third switch S3 and the fourth switch S4 may switch current flowing through the second insulation resistance measuring unit 123. For example, the third switch S3 and the fourth switch S4 may be at least one of a relay or an FET. The third switch S3 and the fourth switch S4 may be controlled by a controller (104, see FIG. 2).

The second reference resistor R2 may be an insulation resistance that is a criterion for determining the insulation state of the ground line 112 of the battery swapping apparatus 11-1. According to an embodiment, when the ground line 112 is in the normal insulation state, a second insulation resistance value measured by the second insulation resistance measuring unit 123 may be the same as a value of the second reference resistor R2 or within an equivalent range thereto. The value of the second reference resistor R2 may be, but not limited to, between n*10³ Ω (kΩ) and n*10⁶ Ω (MΩ), in which n is a value between 1 and 1000.

According to an embodiment, when the insulation of the ground line 112 is broken down, the insulation resistance value of the ground line 112 may be measured as if a resistor R_{y} (not shown) having a value less than the second reference resistor R2 is connected in prallel to the second reference resistor R2. In this case, the value of the resistor R_{y} may be less than the value of the second reference resistor R2. The value of the resistor R_{y} may be, but not limited to, between n Ω and n*10³ Ω (kΩ), in which n is a value between 1 and 1000. According to an embodiment, when the ground line 112 is in the insulation breakdown state, the measured second insulation resistance value may be less than a half of the value of the second reference resistor R2.

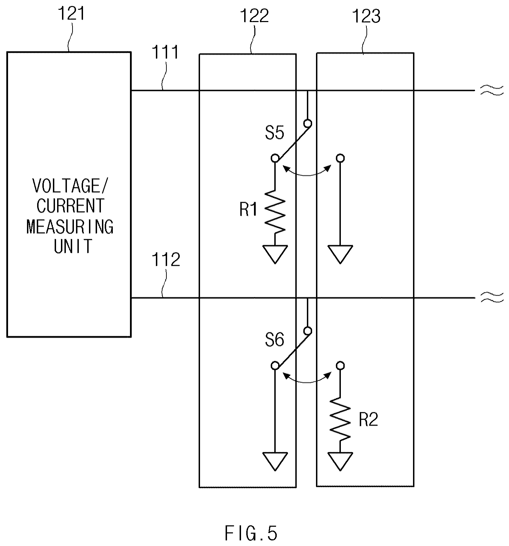

In an embodiment of FIG. 4, to switch current flowing through the first insulation resistance measuring unit 122 and the second insulation resistance measuring unit 123, four switches of a single pole single through (SPST) type (i.e., the first to fourth switches S1, S2, S3, and S4) are shown, but the embodiment of the present disclosure is not limited to the embodiment of FIG. 4. According to another embodiment, the type, structure, number, etc., of switches (or relays or FETs) may be changed according to normal creativity. In this regard, an embodiment of an alternative switch will be described with reference to FIG. 5.

Continuing to refer to the embodiment of FIG. 4, the voltage/current measuring unit 121 may apply current to measure the insulation resistance of the first insulation resistance measuring unit 122 or the second insulation resistance measuring unit 123. According to an embodiment, the voltage/current measuring unit 121 may measure an insulation resistance through the first insulation resistance measuring unit 122 or the second insulation resistance measuring unit 123 under control of the controller 104. For example, the controller 104 may control current to flow through only the first insulation resistance measuring unit 122 including the first reference resistor R1 and current not to flow through the second insulation resistance measuring unit 123 including the second reference resistor R2.

The controller 104 may measure the first insulation resistance based on the current flowing through the first insulation resistance measuring unit 122. In this case, the current may not flow through the second insulation resistance measuring unit 123.

The controller 104 may control operations of the first switch S1, the second switch S2, the third switch S3, and the fourth switch S4 to allow the current to flow through only the first insulation resistance measuring unit 122. More specifically, the controller 104 may control the first through fourth switches S1 to S4 such that the first switch S1 and the second switch S2 are shortcircuited and the third switch S3 and the fourth switch S4 are opened. In this case, a closed circuit (closed loop) including the voltage/current measuring unit 121, the power line 111, the first insulation resistance measuring unit 122, and the ground line 112 may be formed. Thereafter, the voltage/current measuring unit 121 may apply current to the insulation resistance measuring unit. In this case, current may flow through a closed circuit including the first insulation resistance measuring unit 122, and current may not flow through the second insulation resistance measuring unit 123. The voltage/current measuring unit 121 may measure current passing through the first insulation resistance measuring unit 122 or voltage at opposite ends of the first insulation resistance measuring unit 122. The voltage/current measuring unit 121 may measure the first insulation resistance, which is an insulation resistance of the power line 111, based on the current or voltage measured by the first insulation resistance measuring unit 122.

According to an embodiment, when the voltage/current measuring unit 121 may include an EIS measurement system, the voltage/current measuring unit 121 may measure the impedance of the first insulation resistance measuring unit 122.

The controller 104 may determine the insulation state of the power line 111, based on the insulation resistance (or impedance) value measured by the first insulation resistance measuring unit 122. The controller 104 may compare the first insulation resistance value measured by the first insulation resistance measuring unit 122 with the value of the first reference resistor R1 of the power line 111 to determine whether the power line 111 is in the normal insulation state or the insulation breakdown state.

When the measured first insulation resistance value is greater than or equal to the value of the first reference resistor R1, the controller 104 may determine that the power line 111 is in the normal insulation state. When the measured first insulation resistance value is less than the value of the first reference resistor R1, the controller 104 may determine that the power line 111 is in the insulation breakdown state.

When the insulation of the power line 111 is broken down as described above, the first insulation resistance may be measured as if the resistor Rₓ of a value less than that of the first reference resistor R1 is connected in parallel to the power line 111. Thus, in measurement of the insulation resistance of the power line 111 in which insulation is broken down, the first insulation resistance value less than the value of the first reference resistor R1 may be measured.

When the power line 111 is in the insulation breakdown state, maintenance of the battery swapping apparatus 11-1 may be required. When the ground line 112 is in the insulation breakdown state even in the normal insulation state of the power line 111, maintenance of the battery swapping apparatus 11-1 may be required. Thus, the controller 104 may measure both the insulation resistance of the power line 111 and the insulation resistance of the ground line 112 for safe use of the battery swapping apparatus 11-1.

Using a method similar to the insulation resistance measurement of the power line 111, the insulation resistance of the ground line 112, i.e., the second insulation resistance may be measured.

According to an embodiment, the controller 104 may control current to flow through only the second insulation resistance measuring unit 123 including the second reference resistor R2 and current not to flow through the first insulation resistance measuring unit 122 including the first reference resistor R1. The controller 104 may control operations of the first switch S1, the second switch S2, the third switch S3, and the fourth switch S4 to allow the current to flow through only the second insulation resistance measuring unit 123.

More specifically, the controller 104 may control the first through fourth switches S1 to S4 such that the third switch S3 and the fourth switch S4 are shortcircuited and the first switch S1 and the second switch S2 are opened. In this case, a closed circuit (closed loop) including the voltage/current measuring unit 121, the power line 111, the first insulation resistance measuring unit 123, and the ground line 122 may be formed. Thereafter, the voltage/current measuring unit 121 may apply current to the insulation resistance measuring unit. In this case, current may flow through a closed circuit including the second insulation resistance measuring unit 123, and current may not flow through the first insulation resistance measuring unit 122. The voltage/current measuring unit 121 may measure current passing through the second insulation resistance measuring unit 123 or voltage at opposite ends of the second insulation resistance measuring unit 123. The voltage/current measuring unit 121 may measure the second insulation resistance, which is an insulation resistance of the ground line 112, based on the current or voltage measured by the second insulation resistance measuring unit 123.

According to an embodiment, when the voltage/current measuring unit 121 may include an EIS measurement system, the voltage/current measuring unit 121 may measure the impedance of the second insulation resistance measuring unit 123.

The controller 104 may determine the insulation state of the ground line 112, based on the insulation resistance (or impedance) value measured by the second insulation resistance measuring unit 123. The controller 104 may compare the second insulation resistance value measured by the second insulation resistance measuring unit 123 with the value of the second reference resistor R2 of the ground line 112 to determine whether the ground line 112 is in the normal insulation state or the insulation breakdown state.

When the measured second insulation resistance value is greater than or equal to the value of the second reference resistor R2, the controller 104 may determine that the ground line 112 is in the normal insulation state. When the measured second insulation resistance value is less than the value of the second reference resistor R2, the controller 104 may determine that the ground line 112 is in the insulation breakdown state.

When the insulation of the ground line 112 is broken down as described above, the second insulation resistance may be measured as if the resistor R_{y} of a value less than that of the second reference resistor R2 is connected in parallel to the ground line 112. Thus, in measurement of the insulation resistance of the ground line 112 in which insulation is broken down, the second insulation resistance value less than the value of the second reference resistor R2 may be measured.

When the ground line 112 is in the insulation breakdown state, maintenance of the battery swapping apparatus 11-1 may be required. When the power line 111 is in the insulation breakdown state even in the normal insulation state of the ground line 112, maintenance of the battery swapping apparatus 11-1 may be required.

As described above, when insulation of one of the power line 111 or the ground line 112 is broken down, charging/discharging of the battery may have a problem due to high current or high voltage. A damage may also occur in the battery swapping system 1. Thus, for maintenance of the battery swapping system 1 or safety of the user of the battery swapping system 1, it may be important to measure and manage the insulation resistance of the battery swapping system 1.

According to an embodiment of the present disclosure, as the controller 104 controls switching of the switch S0 and the first to fourth switches S1, S2, S3, and S4, the insulation resistance of the power line 111 and the insulation resistance of the ground line 112 may be measured respectively. Thus, even when the battery swapping system 1 operates, the insulation resistance of the battery swapping apparatus 11-1 may be conveniently measured and maintained without external manipulation.

FIG. 5 is a circuit diagram showing a battery swapping apparatus according to another embodiment disclosed herein.

Referring to FIG. 5, a fifth switch S5 and a sixth switch S6 are shown as an alternative embodiment of the first to fourth switches S1, S2, S3, and S4. The fifth switch S5 and the sixth switch S6 may switch current flowing through the first insulation resistance measuring unit 122 and the second insulation resistance measuring unit 123. According to an embodiment, the fifth switch S5 and the sixth switch S6 may be of a single pole double through (SPDT) type.

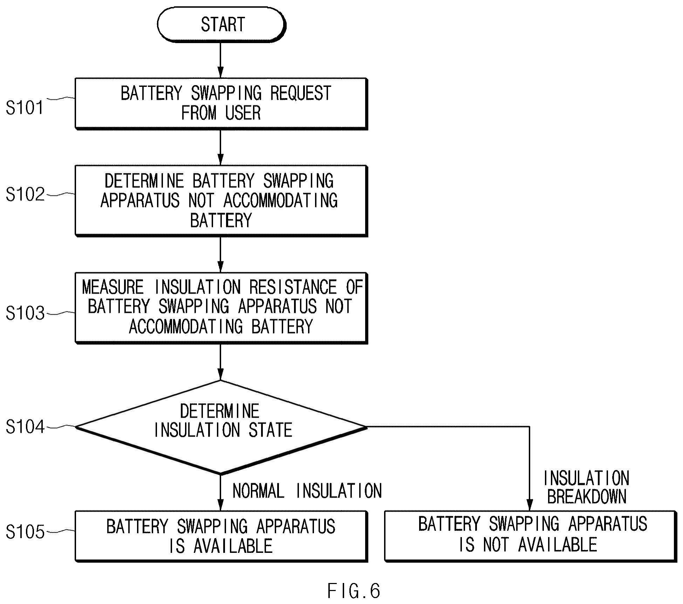

FIG. 6 is an operating flowchart of a battery swapping system according to an embodiment disclosed herein. FIG. 6 may be interpreted with reference to FIGS. 1 to 5.

Referring to FIG. 6, in operation S101, the battery control system 1 may receive a battery swapping request from the user. The battery swapping system 1 may receive the battery swapping request input through the control panel 13. The battery swapping system 1 may receive the battery swapping request, transmitted via a server, through the integrated controller 14. The integrated controller 14 may wiredly or wirelessly receive the battery swapping request from the user.

In operation S102, the battery swapping system 1 may determine whether there is a battery swapping apparatus not accommodating a battery therein among the plurality of battery swapping apparatuses 11-1, 11-2, ..., 11-n. The integrated controller 14 may determine whether a battery is connected to the connecting portion 101. The integrated controller 14 may determine the battery swapping apparatus (e.g., 11-1) not accommodating or not occupied by the battery as the battery swapping apparatus not accommodating the battery.

In operation S103, the integrated controller 14 may transmit an insulation resistance measurement request of the battery swapping apparatus 11-1 not accommodating a battery to the controller 104 of the battery swapping apparatus 11-1. The controller 104 may control the measuring unit 103 to measure the insulation resistance of the battery swapping apparatus 11-1. The measuring unit 103 may measure at least one of the first insulation resistance of the power line 111 and the second insulation resistance of the ground line 112. A method of measuring an insulation resistance is the same as the foregoing description, and thus will not be repeatedly described at this time.

In operation S104, the controller 104 may determine the insulation state of the battery swapping apparatus 11-1, based on the measured first insulation resistance of the power line 111 and the measured second insulation resistance of the ground line 112. The controller 104 may compare the insulation resistance value measured in the battery swapping apparatus 11-1 not accommodating a battery with a reference resistance value. The controller 104 may determine, based on a result of comparison, whether the battery swapping apparatus 11-1 is in the normal insulation state or the insulation breakdown state. A method of measuring an insulation state is the same as the foregoing description, and thus will not be repeatedly described at this time.

The controller 104 may transmit the insulation state of the battery swapping apparatus 11-1 to the integrated controller 14. The controller 104 may transmit, to the integrated controller 14, whether the battery swapping apparatus 11-1 is in the normal insulation state or the insulation breakdown state.

In operation S105, the integrated controller 14 may determine, based on the insulation state of the battery swapping apparatus 11-1, whether the battery swapping apparatus 11-1 is available.

According to an embodiment, when it is determined that the battery swapping apparatus 11-1 is in the normal insulation state, the integrated controller 14 may determine that the battery swapping apparatus 11-1 is available. Thus, the integrated controller 14 may provide the battery swapping apparatus 11-1 for use of the user.

On the other hand, when it is determined that the battery swapping apparatus 11-1 is in the insulation breakdown state, the integrated controller 14 may determine that the battery swapping apparatus 11-1 is not available. Thus, the integrated controller 14 may not provide the battery swapping apparatus 11-1 to the user.

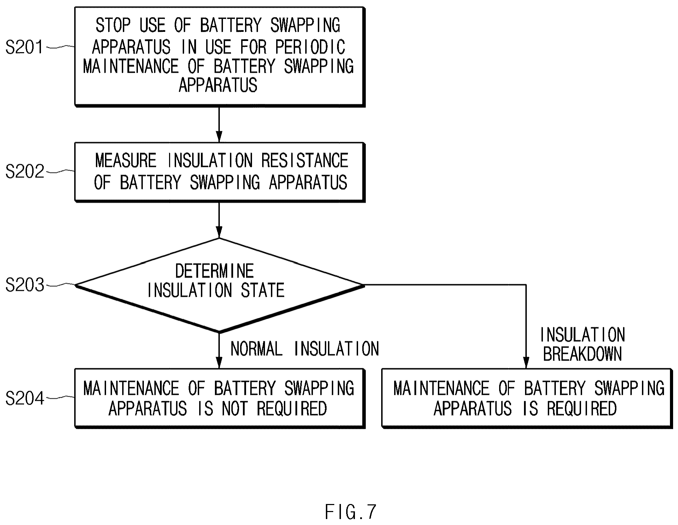

FIG. 7 is an operating flowchart of a battery swapping system according to another embodiment disclosed herein. FIG. 7 may be interpreted with reference to FIGS. 1 to 5.

Referring to FIG. 7, in operation S201, the battery swapping system 1 may periodically measure the insulation resistances of the plurality of battery swapping apparatuses 11-1, 11-2, ..., 11-n. The battery swapping system 1 may stop use of a battery swapping apparatus in use among the plurality of battery swapping apapratuses 11-1, 11-2, ..., 11-n, for insulation resistance measurement.

According to an embodiment, some battery swapping apparatuses (e.g., 11-1 and 11-2) among the plurality of battery swapping apparatuses 11-1, 11-2, ..., 11-n in the battery swapping system 1 may not be in use. The other some battery swapping apparatuses (e.g., 11-3 to 11-n) may be in use. The integrated controller 14 may stop the use of the battery swapping apapratuses 11-3 to 11-n in use at predetermined first time intervals. According to an embodiment, the controller 104 of each of the battery swapping apparatuses 11-3 to 11-n in use may stop charging of each of the battery swapping apparatuses 11-3 to 11-n in use. The controller 104 may block electrical connection between the power 12 and the battery being charged. For example, the controller 104 may control the power switch 102 of each of the battery swapping apparatuses 11-3 to 11-n to be opened.

Thereafter, the integrated controller 14 may trasnmit the insualtion resistance measurement request to the controller 104 of each of the plurality of battery swapping apparatuses 11-1, 11-2, ..., 11-n.

In operation S202, the controller 104 may measure the insulation resistance of each of the plurality of battery swapping apparatuses 11-1, 11-2, ..., 11-n. The controller 104 may control the measuring unit 103 to measure the insulation resistance of each of the plurality of battery swapping apparatus 11-1, 11-2, ..., 11-n. The measuring unit 103 may measure at least one of the first insulation resistance of the power line 111 and the second insulation resistance of the ground line 112. A method of measuring an insulation resistance is the same as the foregoing description, and thus will not be repeatedly described at this time.

In operation S203, the controller 104 of each of the plurality of battery swapping apparatuses 11-1, 11-2, ..., 11-n may determine the insulation state of each of the plurality of battery swapping apparatuses 11-1, 11-2, ..., 11-n, based on the measured first insulation resistance of the power line 111 and the measured second insulation resistance of the ground line 112. A method of measuring an insulation state is the same as the foregoing description, and thus will not be repeatedly described at this time.

The controller 104 may transmit the insulation state of each of the plurality of battery swapping apparatuses 11-1, 11-2, ..., 11-n to the integrated controller 14. The controller 104 may transmit, to the integrated controller 14, whether the battery swapping apparatus 11-1 is in the normal insulation state or the insulation breakdown state.

In operation S204, the integrated controller 14 may determine, based on the insulation state of each of the plurality of battery swapping apparatuses 11-1, 11-2, ..., 11-n, whether maintenance of each of the plurality of battery swapping apparatuses 11-1, 11-2, ..., 11-n is required.

According to an embodiment, when it is determined that the battery swapping apparatus 11-1 is in the normal insulation state, the integrated controller 14 may determine that maintenance of the battery swapping apparatus 11-1 is not required. When the battery swapping apparatus determined to be in the normal insulation state is the battery swapping apparatus 11-3 in use, the integrated controller 14 may resume use of the battery swapping apparatus 11-3 by the controller 104 of the battery swapping apparatus 11-3. For example, the controller 104 may resume charging of the battery accommodated in the battery swapping apparatus 11-3.

According to another embodiment, when it is determined that the battery swapping apparatus 11-1 is in the insulation breakdown state, the integrated controller 104 may determine that maintenance of the battery swapping apparatus 11-1 is required. When the battery swapping apparatus determined to be in the insulation breakdown state is the battery swapping apparatus 11-3 in use, the integrated controller 14 may resume use of the battery swapping apparatus 11-3. Thus, the integrated controller 14 may also transmit a maintenance request for the battery swapping apparatus 11-3 to the server.

Through such an operation of the battery swapping system 1, safety of each of the plurality of battery swapping apparatus 11-1, 11-2, ..., 11-n may be periodically evaluated. Moreover, the battery swapping system 1 may efficiently maintain itself independently.

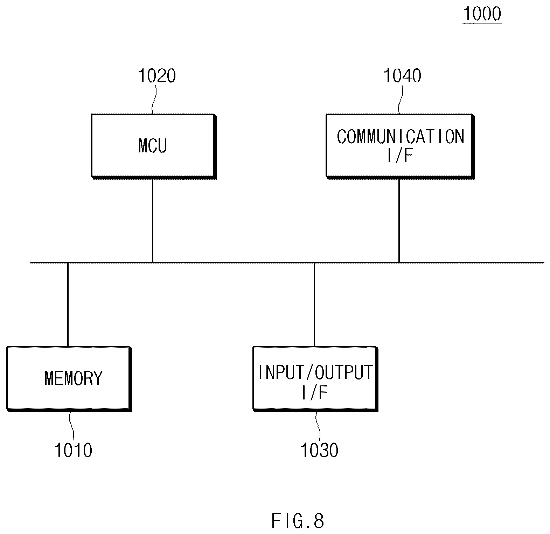

FIG. 8 is a block diagram showing a hardware configuration of a computing system for implementing a battery swapping apparatus according to an embodiment disclosed herein.

Referring to FIG. 8, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell feature data collection program, a latent variable extraction program, a distribution generation program, a battery cell diagnosis program, etc.) stored in the memory 1020, processes various information including feature data, latent variables, etc., of the battery cell through these programs, and executes the above-described functions of the integrated controller 14 or the controller 104 included in the battery swapping system 1 shown in FIGS. 1 to 7.

The memory 1020 may store various programs such as a battery cell feature data collection program, a latent variable extraction program, a distribution generation program, a battery cell diagnosis program, etc. Moreover, the memory 1020 may store various information such as feature data, a latent variable, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery swapping system 1 may transmit and receive various information including SOC, OCV, parameter, etc., of the battery cell from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure and may various changes, substitutions, and modifications may be made herein without departing from the scope of the present disclosure.

### [Description of Symbols]

1: Battery Swapping System
11-1, 11-2, ..., 11-n: Battery Swapping Apparatus
12: Power Source
13: Control Panel
14: Integrated Controller
101: Connecting Portion
102: Power Switch
103: Measuring Unit
104: Controller
111: Power Line
112: Ground Line
113: Communication Line
121: Voltage/Current Measuring Unit
122: First Insulation Resistance Measuring Unit
123: Second Insulation Resistance Measuring Unit
SO, S1, S2, S3, S4: Switch

## Claims

1. A battery swapping system comprising:
a plurality of battery swapping apparatuses configured to accommodate swappable batteries; and
an integrated controller configured to manage operations of the plurality of battery swapping apparatuses, measure an insulation resistance related to each of the plurality of battery swapping apparatuses, and manage use of the battery swapping apparatus based on the measured insulation resistance.

2. The battery swapping system of claim 1, wherein the integrated controller is further configured to determine whether there is a battery swapping apparatus not accommodating a battery among the plurality of battery swapping apparatuses upon receiving a battery swapping request from a user, and manage use of the battery swapping apparatus not accommodating the battery, based on an insulation resistance of the battery swapping apparatus not accommodating the battery.

3. The battery swapping system of claim 1, wherein the integrated controller is further configured to determine whether maintenance of each battery swapping apparatus is required, by measuring the insulation resistance of each of the plurality of battery swapping apparatuses at predetermined first time intervals.

4. The battery swapping system of claim 3, wherein the integrated controller is further configured to determine whether there is a battery swapping apparatus in use among the plurality of battery swapping apparatuses, stop use of the battery swapping apparatus in use, and measure the insulation resistance of each of the plurality of battery swapping apparatuses.

5. The battery swapping system of claim 1, wherein each of the plurality of battery swapping apparatuses comprises:
a connecting portion to which a battery is connected;
a measuring unit configured to measure an insulation resistance of at least any one of a first line and a second line connecting a power source for charging the battery to the connecting portion; and
a controller configured to control the measuring unit and determine an insulation state of at least any one of the first line and the second line, based on the measured insulation resistance.

6. The battery swapping system of claim 5, wherein the measuring unit comprises:
a first insulation resistance measuring unit configured to measure a first insulation resistance that is an insulation resistance of the first line; and
a second insulation resistance measuring unit configured to measure a second insulation resistance that is an insulation resistance of the second line.

7. The battery swapping system of claim 6, wherein the controller is further configured to control each of the first insulation resistance measuring unit and the second insulation resistance measuring unit to measure at least any one of the first insulation resistance and the second insulation resistance, determine an insulation state of the first line based on the measured first insulation resistance, and determine an insulation state of the second line based on the measured second insulation resistance.

8. The battery swapping system of claim 6, wherein the first insulation resistance measuring unit comprises:
a first reference resistor connected between the first line and a ground terminal;
a first switch connected to the first reference resistor; and
a second switch connected between the second line and the ground terminal, and
the second insulation resistance measuring unit comprises:
a second reference resistor connected in parallel to the second switch and connected between the second line and the ground terminal;
a third switch connected to the second reference resistor; and
a fourth switch connected in parallel to the first reference resistor and connected between the first line and the ground terminal.

9. The battery swapping system of claim 8, wherein the controller is further configured to:
measure the first insulation resistance by controlling operations of the first switch, the second switch, the third switch, and the fourth switch such that current flows through the first insulation resistance and current does not flow through the second insulation resistance; and
measure the second insulation resistance by controlling the operations of the first switch, the second switch, the third switch, and the fourth switch such that current does not flow through the first insulation resistance and current flows through the second insulation resistance.

10. The battery swapping system of claim 8, wherein the controller is further configured to:
determine that the first line is in an insulation breakdown state when the measured first insulation resistance is less than the first reference resistance; and
determine that the second line is in the insulation breakdown state when the measured second insulation resistance is less than the second reference resistance.

11. The battery swapping system of claim 5, wherein each of the plurality of battery swapping apparatuses further comprises a power switch configured to switch electrical connection between the power source and the connecting portion.

12. The battery swapping system of claim 11, wherein the controller is further configured to open the power switch before measurement of the insulation resistance of at least any one of the first line and the second line.

13. A management method of a battery swapping apparatus, the management method comprising:
measuring an insulation resistance of each of a plurality of battery swapping apparatuses configured to accommodate swappable batteries; and
managing use of each of the plurality of battery swapping apparatuses, based on the measured insulation resistance.

14. The management method of claim 13, wherein the measuring of the insulation resistance comprises:
receiving a battery swapping request from a user;
determining whether there is a battery swapping apparatus not accommodating a battery among the plurality of battery swapping apparatuses; and
measuring an insulation resistance of the battery swapping apparatus not accommodating the battery, and
the managing of the use of the battery swapping apparatus comprises determining an insulation state of the battery swapping apparatus not accommodating the battery, based on the measured insulation resistance and determining, based on the determined insulation state, whether to provide the battery swapping apparatus to the user.

15. The management method of claim 13, wherein the measuring of the insulation resistance comprises measuring the insulation resistance of each of the plurality of battery swapping apparatuses at predetermined first time intervals, and
the managing of the use of the battery swapping apparatus comprises determining an insulation state of each battery swapping apparatus, based on the measured insulation resistance and determining, based on the determined insulation state, whether maintenance of each battery swapping apparatus is required.

16. The management method of claim 15, further comprising, before the measuring of the insulation resistance of each of the plurality of battery swapping apparatuses, determining whether there is a battery swapping apparatus in use among the plurality of battery swapping apparatuses and stopping use of the battery swapping apparatus in use.

17. A battery swapping apparatus comprising:
a connecting portion to which a battery is connected;
a measuring unit configured to measure an insulation resistance of at least any one of a first line and a second line connecting a power source for charging the battery to the connecting portion; and
a controller configured to control the measuring unit and determine an insulation state of at least any one of the first line and the second line, based on the measured insulation resistance.

18. The battery swapping apparatus of claim 17, wherein the measuring unit comprises:
a first insulation resistance measuring unit configured to measure a first insulation resistance that is an insulation resistance of the first line; and
a second insulation resistance measuring unit configured to measure a second insulation resistance that is an insulation resistance of the second line.

19. The battery swapping apparatus of claim 17, further comprising a power switch configured to switch electrical connection between the power source and the connecting portion.
